# EUROPEAN PATENT APPLICATION

(11) **EP 4 668 072 A1**
(43) Date of publication of application: **24.12.2025**
(21) Application number: 24756187.1
(22) Date of filing: 07.02.2024
(51) Int. Cl.: G06F 3/041

(54) **HAPTIC SIGNAL ENCODING METHOD AND APPARATUS, HAPTIC SIGNAL DECODING METHOD AND APPARATUS, AND DEVICE**

(30) Priority: 16.02.2023 CN 202310125338; 23.03.2023 CN 202310292554
(71) Applicant: Vivo Mobile Communication Co., Ltd., Dongguan, Guangdong 523863 (CN); Dalian University of Technology, Dalian, Liaoning 116024 (CN)
(72) Inventor: LIU, Qian, Dongguan, Guangdong 523863 (CN); CAI, Wenhao, Dongguan, Guangdong 523863 (CN); LIN, Huhu, Dongguan, Guangdong 523863 (CN); HE, Dazhong, Dongguan, Guangdong 523863 (CN); LV, Zhuoyi, Dongguan, Guangdong 523863 (CN)
(74) Representative: Lavoix
(86) International application number: PCT/CN2024/076505
(87) International publication number: WO 2024/169814

(57) **Abstract**

This application provides a tactile signal encoding method, a tactile signal decoding method, an apparatus, and a device. The tactile signal encoding method includes: obtaining N first tactile signals; generating M first signal blocks according to the N first tactile signals; determining, according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block; filtering out, based on the temporal-spatial masking threshold matrix corresponding to each first signal block, part secondary tactile signals included in each first signal block to obtain M second signal blocks; and encoding N second tactile signals to generate a target bitstream.

## Description

### CROSS-REFERENCE TO RELATED APPLICATIONS

This application claims priority to Chinese Patent Application No. 202310125338.9 filed in China on February 16, 2023, and Chinese Patent Application No. 202310292554.2 filed in China on March 23, 2023, which are incorporated herein by reference in their entirety.

### TECHNICAL FIELD

This application belongs to the technical field of encoding and decoding, and specifically, to a tactile signal encoding method, a tactile signal decoding method, an apparatus, and a device.

### BACKGROUND

Tactile information is mainly classified into two types: tactile information based on muscle movement perception, alternatively referred to as kinesthetic information; and tactile information based on skin texture perception, alternatively referred to as texture perception information. In some technical fields, for example, a virtual reality technical field or an automated driving technical field, a tactile signal is generated based on tactile information, and a hardware device transmits the tactile signal to a user, so that the user feels a vibration or a pulse, and tactile perception of the user is increased.

In a related technology, a tactile signal may be compressed through tactile signal encoding. Specifically, single-channel tactile signals are encoded one by one to encode the tactile signal. However, a bitstream obtained by encoding the tactile signal has a large amount of information redundancy.

### SUMMARY

Embodiments of this application provide a tactile signal encoding method, a tactile signal decoding method, an apparatus, and a device, which can resolve a problem that an encoded bitstream has a large amount of information redundancy.

According to a first aspect, a tactile signal encoding method is provided, and is performed by an encoding end. The method includes:
obtaining, by an encoding end, N first tactile signals, where N is a positive integer greater than 1;
generating, by the encoding end, M first signal blocks according to the N first tactile signals, where the first signal block includes part signal sources of the N first tactile signals, and M is a positive integer greater than 1;
determining, by the encoding end according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block, where the first signal block includes the primary tactile signal and a secondary tactile signal;
filtering out, by the encoding end based on the temporal-spatial masking threshold matrix corresponding to each first signal block, part secondary tactile signals included in each first signal block to obtain M second signal blocks; and
encoding, by the encoding end, N second tactile signals to generate a target bitstream, where the N second tactile signals are obtained based on a concatenation operation performed on the M second signal blocks.

According to a second aspect, a tactile signal decoding method is provided, and is performed by a decoding end. The method includes:
obtaining, by a decoding end, a first metadata information packet;
decoding, by the decoding end, the first metadata information packet to obtain second metadata information; and
decoding, by the decoding end, the second metadata information to obtain third information, where
the third information includes spatial information of K third tactile signals, or includes spatial information of K third tactile signals and fourth information, and K is a positive integer greater than 1; and
the fourth information includes at least one of the following:
   mask information associated with each primary tactile signal in the K third tactile signals; and
   model information associated with each primary tactile signal in the K third tactile signals.

According to a third aspect, a tactile signal encoding apparatus is provided. The apparatus includes:
an obtaining module, configured to obtain N first tactile signals, where N is a positive integer greater than 1;
a first generating module, configured to generate M first signal blocks according to the N first tactile signals, where the first signal block includes part signal sources of the N first tactile signals, and M is a positive integer greater than 1;
a first determining module, configured to determine, according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block, where the first signal block includes the primary tactile signal and a secondary tactile signal;
a filtering module, configured to filter out, based on the temporal-spatial masking threshold matrix corresponding to each first signal block, part secondary tactile signals included in each first signal block to obtain M second signal blocks; and
a first encoding module, configured to encode the N second tactile signals to generate a target bitstream, where the N second tactile signals are obtained based on a concatenation operation performed on the M second signal blocks.

According to a fourth aspect, a tactile signal decoding apparatus is provided. The apparatus includes:
a first obtaining module, configured to obtain a first metadata information packet;
a first decoding module, configured to decode the first metadata information packet to obtain second metadata information; and
a first parsing module, configured to parse the second metadata information to obtain third information, where
the third information includes spatial information of K third tactile signals, or includes spatial information of K third tactile signals and fourth information, and K is a positive integer greater than 1; and
the fourth information includes at least one of the following:
   mask information associated with each primary tactile signal in the K third tactile signals; and
   model information associated with each primary tactile signal in the K third tactile signals.

According to a fifth aspect, a terminal is provided. The terminal includes a processor and a memory. The memory stores a program or instructions executable on the processor. The program or instructions implement steps of the method according to the first aspect and steps of the method according to the second aspect when executed by the processor.

According to a sixth aspect, a readable storage medium is provided. The readable storage medium stores a program or instructions. The program or instructions implement steps of the method according to the first aspect, or implement steps of the method according to the second aspect when executed by a processor.

According to a seventh aspect, a chip is provided. The chip includes a processor and a communication interface. The communication interface is coupled to the processor, and the processor is configured to run a program or instructions to implement the method according to the first aspect or implement the method according to the second aspect.

According to an eighth aspect, a computer program/program product is provided. The computer program/program product is stored in a storage medium. The computer program/program product is executed by at least one processor to implement steps of the method according to the first aspect, or implement steps of the method according to the second aspect.

According to a ninth aspect, a system is provided. The system includes an encoding end and a decoding end. The encoding end performs steps of the method according to the first aspect, and the decoding end performs steps of the method according to the second aspect.

In this embodiment of this application, N first tactile signals are obtained; M first signal blocks are generated according to the N first tactile signals; a temporal-spatial masking threshold matrix corresponding to each first signal block is determined according to spatial information of the N first tactile signals, a target signal amplitude corresponding to a primary tactile signal in each first signal block, and a target frequency corresponding to the primary tactile signal in each first signal block; part secondary tactile signals included in each first signal block are filtered out based on the temporal-spatial masking threshold matrix corresponding to each first signal block to obtain M second signal blocks; and the N second tactile signals are encoded to generate a target bitstream. Compared with a to-be-coded tactile signal in a related technology, in this embodiment of this application, a temporal-spatial masking threshold matrix is determined according to spatial information of a tactile signal, a target signal amplitude corresponding to each primary tactile signal, and a target frequency corresponding to a primary tactile signal in each first signal block, and then redundant secondary tactile signals are filtered out through the temporal-spatial masking threshold matrix. In this way, mutual masking effects of the tactile signal in time and space are considered during encoding, thereby reducing information redundancy of the target bitstream obtained by encoding, and improving encoding efficiency.

### BRIEF DESCRIPTION OF THE DRAWINGS

FIG. 1 is a schematic flowchart of a tactile signal encoding method according to an embodiment of this application;
FIG. 2 is a schematic diagram of a spatial pattern mask according to an embodiment of this application;
FIG. 3 is a schematic diagram of a spatial masking threshold matrix according to an embodiment of this application;
FIG. 4 is a schematic flowchart of a tactile signal decoding method according to an embodiment of this application;
FIG. 5 is a structural diagram of a tactile signal encoding apparatus according to an embodiment of this application;
FIG. 6 is a structural diagram of a tactile signal decoding apparatus according to an embodiment of this application;
FIG. 7 is a structural diagram of a communication device according to an embodiment of this application; and
FIG. 8 is a schematic diagram of a hardware structure of a terminal according to an embodiment of this application.

### DETAILED DESCRIPTION

Technical solutions in embodiments of this application will be clearly described in the following with reference to accompanying drawings in the embodiments of this application. Apparently, the described embodiments are merely some rather than all of the embodiments of this application. Based on the embodiments of this application, all other embodiments obtained by those of ordinary skill in the art fall within the protection scope of this application.

Terms "first", "second", and the like in this application are used for distinguishing similar objects, but are not used for describing a specific order or sequence. It is to be understood that the terms used in this way are exchangeable in a proper case, so that the embodiments of this application can be implemented in a sequence other than sequences graphically shown or described here, and objects distinguished by "first" and "second" are usually of the same class without limiting a number of the objects, for example, a first object may be one or more. In addition, "or" in this application represents at least one of connected objects. For example, "A or B" covers three solutions, that is, solution 1: including A and excluding B; solution 2: including B and excluding A; and solution 3: including both A and B. Character "/" generally indicates an "or" relationship between associated objects before and after.

Term "indication" in this application may be a direct indication (or an explicit indication), or may be an indirect indication (or an implicit indication). The direct indication may be understood as that a sending party explicitly notifies a receiving party of content such as specific information, an operation that needs to be performed, or a request result in a sent indication. The indirect indication may be understood as that the receiving party determines corresponding information according to an indication sent by the sending party, or performs determining and determines an operation that needs to be performed or a request result according to a determination result.

In a related technology, a tactile signal includes a primary tactile signal and a secondary tactile signal. In a process of encoding the tactile signal, the primary tactile signal generates a spatial masking effect on a spatially adjacent secondary tactile signal in a time period. It is to be understood that the spatial masking effect generated by the primary tactile signal makes it difficult for a human body to sense the secondary tactile signal. Therefore, the secondary tactile signal that cannot be sensed by the human body may be defined as redundant tactile information. However, in the process of encoding the tactile signal in the related technology, a mutual masking effect between tactile signals is ignored, which results in that an encoded bitstream has a large amount of information redundancy.

To solve the technical problems, an embodiment of this application provides a tactile signal encoding method. The tactile signal encoding method that is provided in this embodiment of this application and that is applied to an encoding end is described in detail below through some embodiments and application scenarios thereof with reference to accompanying drawings.

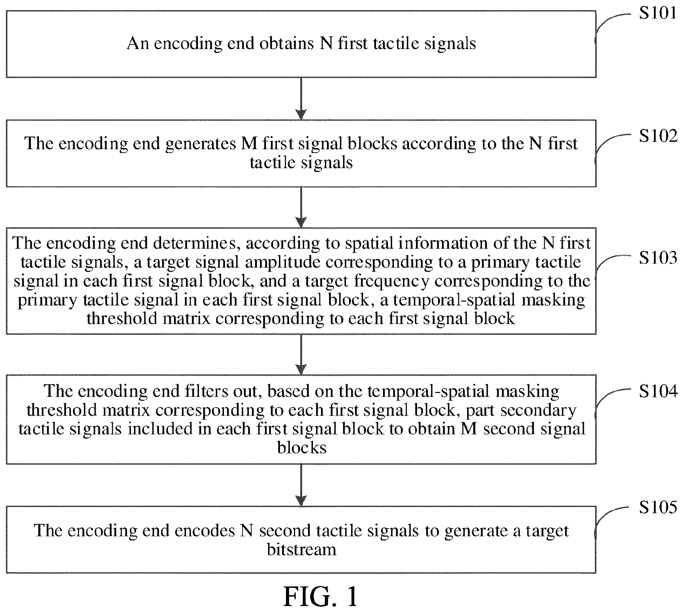

FIG. 1 is a flowchart of a tactile signal encoding method according to an embodiment of this application. The tactile signal encoding method provided in this embodiment includes the following steps:
S101: An encoding end obtains N first tactile signals.

In this step, the encoding end obtains N tactile signals, and the tactile signals are referred to as first tactile signals, where N is a positive integer greater than 1.

S102: The encoding end generates M first signal blocks according to the N first tactile signals.

In this step, after obtaining the N first tactile signals, the encoding end may perform partitioning processing on the N first tactile signals to generate M first signal blocks. A length of the first signal block may be 32, 64, 128, 256, 512, or another length. It is to be understood that the N first tactile signals may be obtained by performing a concatenation operation on the M first signal blocks after the partitioning processing. For a specific implementation, please refer to subsequent embodiments.

The first signal block includes signal sources of the N first tactile signals in part time periods, that is, the first signal block includes part signal sources of the N first tactile signals, and M is a positive integer greater than 1.

S103: The encoding end determines a temporal-spatial masking threshold matrix corresponding to each first signal block according to spatial information of the N first tactile signals, a target signal amplitude corresponding to a primary tactile signal in each first signal block, and a target frequency corresponding to the primary tactile signal in each first signal block.

The first signal block includes the primary tactile signal and a secondary tactile signal. One first signal block includes at least one primary tactile signal, and one primary tactile signal is associated with at least one secondary tactile signal. For a specific technical solution about how to determine the primary tactile signal and the secondary tactile signal, please refer to subsequent embodiments.

The spatial information includes, but is not limited to: information of a human body area to which the first tactile signals belong, position information of the human body area to which the first tactile signals belong, and relative position information between the first tactile signals.

The temporal-spatial masking threshold matrix is a three-dimensional matrix. The temporal-spatial masking threshold matrix may represent a masking effect of the primary tactile signal on a spatially adjacent secondary tactile signal in time.

The target frequency corresponding to the primary tactile signal may be a frequency component having a maximum signal amplitude in the spectrum information of the primary tactile signal.

In this step, the encoding end may determine the temporal-spatial masking threshold matrix corresponding to each first signal block according to the spatial information of the N first tactile signals, the target signal amplitude corresponding to the primary tactile signal in each first signal block, and the target frequency corresponding to the primary tactile signal in each first signal block. The temporal-spatial masking threshold matrix is in a mapping correspondence with the primary tactile signal. For a specific implementation, please refer to subsequent embodiments.

S104: The encoding end filters out, based on the temporal-spatial masking threshold matrix corresponding to each first signal block, part secondary tactile signals included in each first signal block to obtain M second signal blocks.

In this step, for each first signal block, part secondary tactile signals included in the first signal block are filtered out based on the temporal-spatial masking threshold matrix corresponding to the first signal block to obtain a second signal block, so as to obtain the M second signal blocks. It is easy to understand that compared with the first signal block, the second signal block filters out part redundant secondary tactile signals.

S105: The encoding end encodes the N second tactile signals to generate a target bitstream.

In this step, after the M second signal blocks are obtained, a concatenation operation is performed on the M second signal blocks to obtain the N second tactile signals, and the N second tactile signals are encoded to generate the target bitstream. Optionally, a moving picture experts group (Moving Picture Experts Group, MPEG) compression technology may be used for compressing and encoding the N second tactile signals to generate the target bitstream.

In this embodiment of this application, N first tactile signals are obtained; M first signal blocks are generated according to the N first tactile signals; a temporal-spatial masking threshold matrix corresponding to each first signal block is determined according to spatial information of the N first tactile signals, a target signal amplitude corresponding to a primary tactile signal in each first signal block, and a target frequency corresponding to the primary tactile signal in each first signal block; part secondary tactile signals included in each first signal block are filtered out based on the temporal-spatial masking threshold matrix corresponding to each first signal block to obtain M second signal blocks; and the N second tactile signals are encoded to generate a target bitstream. Compared with a to-be-coded tactile signal in a related technology, in this embodiment of this application, a temporal-spatial masking threshold matrix is determined according to spatial information of a tactile signal, a target signal amplitude corresponding to each primary tactile signal, and a target frequency corresponding to a primary tactile signal in each first signal block, and then redundant secondary tactile signals are filtered out through the temporal-spatial masking threshold matrix. In this way, mutual masking effects of the tactile signal in time and space are considered during encoding, thereby reducing information redundancy of the target bitstream obtained by encoding, and improving encoding efficiency.

Optionally, the determining, according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block includes:
generating, for each first signal block, a spatial pattern mask associated with each primary tactile signal based on a relative position between each primary tactile signal represented by the spatial information and the at least one secondary tactile signal associated with each primary tactile signal;
determining, according to the spatial pattern mask associated with each primary tactile signal and the spatial information, a psychohaptic masking model associated with each primary tactile signal;
determining, according to the target signal amplitude corresponding to each primary tactile signal and each masking threshold coefficient included in the psychohaptic masking model associated with each primary tactile signal, a spatial masking threshold matrix corresponding to each primary tactile signal; and
obtaining, according to the spatial masking threshold matrix corresponding to each primary tactile signal, at least one temporal-spatial masking threshold matrix corresponding to the first signal block.

As described above, the first signal block includes at least one primary tactile signal and at least one secondary tactile signal associated with the primary tactile signal.

In this embodiment, the spatial information of the N first tactile signals is obtained. As described above, the spatial information includes relative position information between the first tactile signals.

For each first signal block, the spatial pattern mask associated with each primary tactile signal included in the first signal block is generated according to a relative position between each primary tactile signal represented by the spatial information and the at least one secondary tactile signal associated with each primary tactile signal. It is to be understood that the spatial pattern mask is used for representing a spatial position relationship between an associated primary tactile signal and the at least one secondary tactile signal associated with the primary tactile signal.

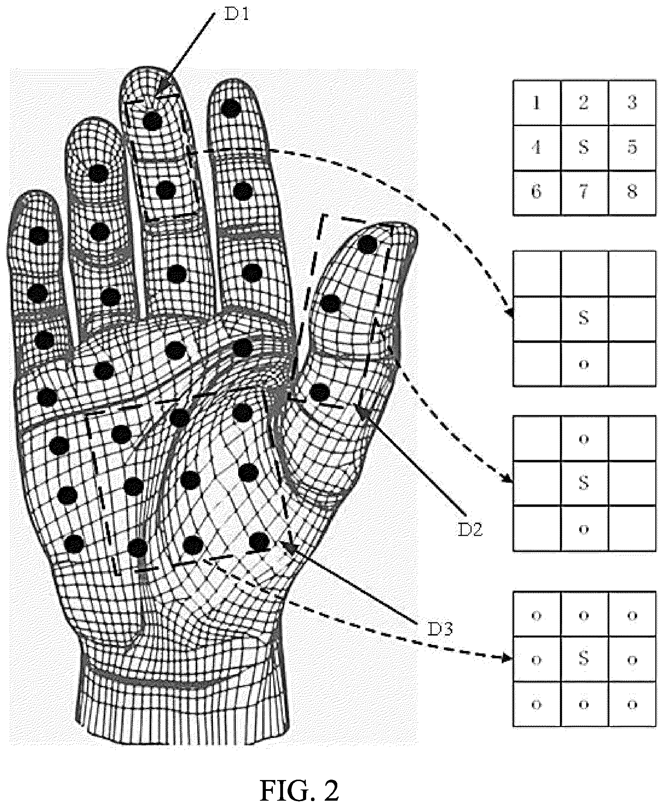

For ease of understanding, FIG. 2 shows part spatial pattern masks determined based on a tactile signal corresponding to a hand area of a human body. A human body area corresponding to an identifier D1 in FIG. 2 is a middle finger area, a spatial pattern mask of the area represents a spatial position relationship between one primary tactile signal and one associated secondary tactile signal, and the secondary tactile signal is located below the primary tactile signal. A human body area corresponding to an identifier D2 in FIG. 2 is a thumb area, a spatial pattern mask of the area represents a spatial position relationship between one primary tactile signal and two associated secondary tactile signals, and the two secondary tactile signals are separately located below and above the primary tactile signal. A human body area corresponding to an identifier D3 in FIG. 2 is a palm region, a spatial pattern mask of the region represents spatial position relationships between one primary tactile signal and associated eight secondary tactile signals, and the eight secondary tactile signals are spatially adjacent to the primary tactile signal.

In this embodiment, a psychohaptic masking model associated with each primary tactile signal may be determined according to the spatial pattern mask and the spatial information associated with each primary tactile signal.

It is to be noted that, for each primary tactile signal, a human body position corresponding to the psychohaptic masking model may be determined according to the information of the human body area included in the spatial information and position information of the human body area to which the primary tactile signal belongs; and a relative position relationship between the primary tactile signal and the secondary tactile signal is determined according to the spatial pattern mask associated with the primary tactile signal to select the psychohaptic masking model associated with the primary tactile signal from a plurality of psychohaptic masking models preset by the encoding end.

For example, the human body position is determined as the middle finger area of the hand based on the spatial information, and the relative position relationship between a primary tactile signal and the secondary tactile signal is determined based on the spatial pattern mask associated with the primary tactile signal, so that a psychohaptic masking model that corresponds to the middle finger area of the hand of the human body and in which the relative position relationship between the primary tactile signal and the secondary tactile signal is the same as the relative position relationship represented by the spatial pattern mask may be selected from the plurality of preset psychohaptic masking models.

It is to be understood that the psychohaptic masking model is obtained by a subjective test. Generally, in the subjective test, it is difficult to test masking effects generated by the primary tactile signals at all frequencies, and only several secondary tactile signals with controlled frequency values are selected to perform a spatial masking effect test. Therefore, a masking threshold coefficient of the masking effect generated by the primary tactile signal at any frequency may be obtained by using an interpolation function.

It is to be understood that the psychohaptic masking model includes at least one masking threshold coefficient, and the masking threshold coefficient is associated with a spatial position of the secondary tactile signal. The masking threshold coefficient is determined based on a target frequency corresponding to an associated primary tactile signal. The primary tactile signal generates different masking effects on the secondary tactile signal at different target frequencies. Therefore, the masking threshold coefficient in the psychohaptic masking model associated with the primary tactile signal is related to the target frequency corresponding to the primary tactile signal.

In this embodiment, after the psychohaptic masking model is obtained, the target frequency corresponding to the primary tactile signal may be determined. For a specific implementation about how to determine the target frequency corresponding to the primary tactile signal, please refer to subsequent embodiments.

In this embodiment, after the psychohaptic masking model associated with each primary tactile signal is determined, the psychohaptic masking model associated with each primary tactile signal may be determined according to the spatial pattern mask and the spatial information associated with each primary tactile signal. For specific implementations, please refer to subsequent embodiments.

It is to be understood that the spatial masking threshold matrix only considers an instantaneous masking effect between spatially adjacent tactile signals, but the masking effect has temporal persistence. Therefore, the spatial masking threshold matrix needs to be further processed.

In this embodiment, the temporal-spatial masking threshold matrix is obtained according to the spatial masking threshold matrix corresponding to each primary tactile signal. The temporal-spatial masking threshold matrix is used for representing a masking effect of the primary tactile signal on a spatially adjacent secondary tactile signal in time, and the temporal-spatial masking threshold matrix is a three-dimensional matrix.

For a specific implementation about how to obtain the temporal-spatial masking threshold matrix according to the spatial masking threshold matrix, please refer to subsequent embodiments.

In this embodiment, a spatial pattern mask is constructed according to a relative spatial position between a primary tactile signal and a secondary tactile signal; a psychohaptic masking model associated with the primary tactile signal is determined according to the spatial pattern mask and spatial information associated with the primary tactile signal; a spatial masking threshold matrix corresponding to each primary tactile signal is determined according to a target signal amplitude corresponding to the primary tactile signal and each masking threshold coefficient included in the psychohaptic masking model associated with the primary tactile signal; and at least one temporal-spatial masking threshold matrix corresponding to the first signal block is obtained according to the spatial masking threshold matrix corresponding to each primary tactile signal. The temporal-spatial masking threshold matrix eliminates persistence of a masking effect of the primary tactile signal on the secondary tactile signal in time, and then redundant secondary tactile signals may be filtered out more accurately by using the temporal-spatial masking threshold matrix.

Optionally, the determining, according to the target signal amplitude corresponding to each primary tactile signal and each masking threshold coefficient included in the psychohaptic masking model associated with each primary tactile signal, the spatial masking threshold matrix corresponding to each primary tactile signal includes:
performing a multiplication operation on the target signal amplitude corresponding to each primary tactile signal and each masking threshold coefficient included in the psychohaptic masking model associated with each primary tactile signal to obtain the spatial masking threshold matrix corresponding to each primary tactile signal.

In this embodiment, the target signal amplitude corresponding to the primary tactile signal is multiplied by each masking threshold coefficient included in the psychohaptic masking model associated with the primary tactile signal to obtain the spatial masking threshold matrix. The spatial masking threshold matrix includes at least one masking threshold, the masking threshold is in a mapping correspondence with the secondary tactile signal, and the masking threshold is used for representing a masking effect of the primary tactile signal on the secondary tactile signal.

For an implementation that how the encoding end may calculate the target signal amplitude corresponding to the primary tactile signal, please refer to subsequent embodiments.

It is to be understood that the spatial masking threshold matrix is a two-dimensional matrix and is used for representing a masking effect of the primary tactile signal on a spatially adjacent secondary tactile signal.

The spatial pattern mask corresponding to an area D1 shown in FIG. 2 represents a spatial position relationship between one primary tactile signal and one associated secondary tactile signal, and a psychohaptic masking model associated with the spatial pattern mask includes one masking threshold coefficient. For example, if the target signal amplitude corresponding to the primary tactile signal is 10, and the masking threshold coefficient is 0.5, the masking threshold matrix corresponding to the primary tactile signal includes one masking threshold, and the masking threshold is a product of the target signal amplitude corresponding to the primary tactile signal and the masking threshold coefficient, that is, 5.

In other embodiments, the target signal amplitude corresponding to the primary tactile signal may be multiplied by each masking threshold coefficient included in the psychohaptic masking model associated with the primary tactile signal, and a multiplication result is then multiplied by a preset weight value to obtain the spatial masking threshold matrix.

Optionally, the obtaining, according to the spatial masking threshold matrix corresponding to each primary tactile signal, at least one temporal-spatial masking threshold matrix corresponding to the first signal block includes:
obtaining, in descending order of signal strength of all primary tactile signals and sequentially according to the spatial masking threshold matrix corresponding to each primary tactile signals, at least one temporal-spatial masking threshold matrix corresponding to the first signal block.

In this embodiment, in a case that the first signal block includes a plurality of primary tactile signals, the primary tactile signals are ranked in descending order of signal strength of the primary tactile signals, and at least one temporal-spatial masking threshold matrix corresponding to the first signal block is obtained according to the spatial masking threshold matrix corresponding to each primary tactile signal based on the ranking.

An optional implementation is that a signal integral value and a signal length of the primary tactile signal are obtained, and a division result between the signal integral value and the signal length is determined as the signal strength of the primary tactile signal.

In this embodiment, the temporal-spatial masking threshold matrix corresponding to the primary tactile signal is determined one by one according to the spatial masking threshold matrix corresponding to each primary tactile signal in descending order of signal strength from of the primary tactile signals, and then redundant secondary tactile signals are filtered out more comprehensively by using the temporal-spatial masking threshold matrix corresponding to each primary tactile signal in a subsequent step.

In other embodiments, if the first signal block includes only one primary tactile signal, the temporal-spatial masking threshold matrix corresponding to the first signal block is directly determined according to the spatial masking threshold matrix corresponding to the primary tactile signal.

Optionally, the obtaining, according to the spatial masking threshold matrix corresponding to each primary tactile signal, at least one temporal-spatial masking threshold matrix corresponding to the first signal block includes:
assigning, for each primary tactile signal, at least one masking threshold at each target position in the spatial masking threshold matrix corresponding to the primary tactile signal to obtain a temporal-spatial masking threshold matrix corresponding to the primary tactile signal.

It is to be understood that, the spatial masking threshold matrix includes at least one target position, and the target position is used for representing a spatial position relationship between the primary tactile signal and the secondary tactile signal. In this embodiment, at least one masking threshold is further assigned to the target position in the spatial masking threshold matrix to convert a two-dimensional spatial masking threshold matrix into a three-dimensional temporal-spatial masking threshold matrix, that is, each target position in the temporal-spatial masking threshold matrix corresponds to at least two masking thresholds. The masking threshold assigned to the target position of the temporal-spatial masking threshold matrix is used for representing a masking effect of the primary tactile signal on the secondary tactile signal in an impact time period.

It is to be noted that, the impact time period is associated with a length of the first signal block. That is, a time period in which the secondary tactile signal is affected by the masking effect generated by the primary tactile signal is limited by a length of a signal block. Specifically, the impact time segment does not exceed half the length of the signal block, and on a premise that a compression fidelity requirement and a processing capability requirement of the encoding end are satisfied, a longer length of the signal block indicates a higher compression rate of the tactile signal and a better compression effect.

For example, the impact time period includes eight impact moments, and the spatial masking threshold matrix includes one masking threshold. In this case, seven masking thresholds are assigned to the target position corresponding to the masking threshold in the spatial masking threshold matrix to obtain the temporal-spatial masking threshold matrix. That is, the temporal-spatial masking threshold matrix includes eight masking thresholds.

Optionally, the temporal-spatial masking threshold matrix that corresponds to each first signal block and that is within the same impact time period is the same, and the impact time period is associated with the length of the first signal block.

It is to be understood that the impact time period includes a plurality of impact moments. As described above, the impact time period does not exceed half the length of the signal block.

The temporal-spatial masking threshold matrixes may be understood as spatial masking threshold matrixes at different impact moments. The spatial masking threshold matrixes at different impact moments in the same impact time period are the same, that is, the temporal-spatial masking threshold matrixes within the same impact time period are the same.

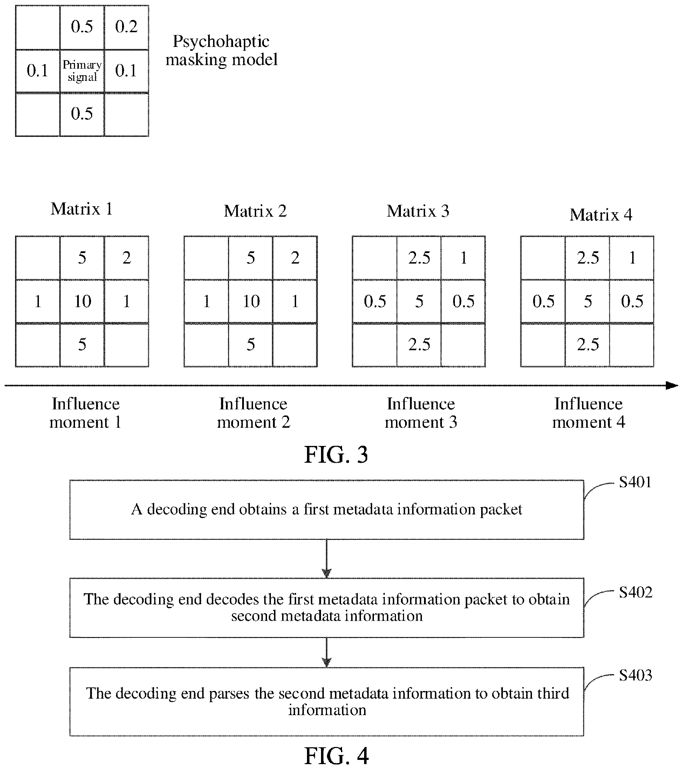

For ease of understanding, please refer to FIG. 3, in a scenario shown in FIG. 3, an impact time period includes two impact moments. FIG. 3 shows a psychohaptic masking model corresponding to a primary tactile signal, and spatial masking threshold matrixes corresponding to the primary tactile signal at different impact moments, respectively, a "matrix 1" corresponding to an "impact moment 1", a "matrix 2" corresponding to an "impact moment 2", a "matrix 3" corresponding to an "impact moment 3", and a "matrix 4" corresponding to an "impact moment 4".

In the scenario shown in FIG. 3, because the "impact moment 1" and the "impact moment 2" belong to the same impact time period, the "matrix 1" is the same as the "matrix 2". Because the "impact moment 3" and the "impact moment 4" belong to the same impact time period, the "matrix 3" is the same as the "matrix 4". In addition, spatial masking threshold matrixes corresponding to different impact time periods are different, that is, the "matrix 1" is different from the "matrix 3".

In this embodiment, the temporal-spatial masking threshold matrix is determined according to the spatial masking threshold matrix by using the masking effect of the primary tactile signal on the secondary tactile signal at different impact moments. Further, in subsequent steps, redundant secondary tactile signals are filtered out more comprehensively by using the temporal-spatial masking threshold matrix corresponding to each primary tactile signal.

Optionally, the generating M first signal blocks according to the N first tactile signals includes:
performing low-pass filtering processing on the N first tactile signals; and
partitioning, by using occurrence time corresponding to the N first tactile signals obtained after the low-pass filtering processing as partitioning points, the N first tactile signals obtained after the low-pass filtering processing to generate M first signal blocks.

In this embodiment, after the N first tactile signals are obtained, the low-pass filtering processing is performed on the N first tactile signals, and the N first tactile signals obtained after the low-pass filtering processing are partitioned by using occurrence time corresponding to the N first tactile signals obtained after the low-pass filtering processing as partitioning points to generate the M first signal blocks. Initial time corresponding to each first tactile signal belonging to the same first signal block is the same.

The occurrence time may be understood as a time in a case that a vibration tactile reproduction device reproduces a tactile signal. It is to be noted that, the occurrence time may alternatively be understood as an input time of inputting the first tactile signal to the encoding end; and the initial time is an earliest input time corresponding to the first tactile signal in the first signal block. In this embodiment, interference of a high-frequency signal that cannot be sensed by a human body in the N first tactile signals is filtered out by performing low-pass filtering processing on the N first tactile signals.

Optionally, before the determining, according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block, the method further includes:
performing, fast Fourier transform on the primary tactile signal in each first signal block to obtain spectrum information of each primary tactile signal; and
determining, for each primary tactile signal, a frequency component having a maximum signal amplitude in spectrum information of the primary tactile signal as the target frequency corresponding to the primary tactile signal.

In this embodiment, for each primary tactile signal, fast Fourier transform is performed on the primary tactile signal to obtain spectrum information of the primary tactile signal, and then a frequency component having a maximum signal amplitude in the spectrum information is determined as the target frequency corresponding to the primary tactile signal.

It is to be understood that, at different frequencies, the primary tactile signal generates different spatial masking effects for the secondary tactile signal. In this embodiment, the spectrum information of the primary tactile signal is obtained by performing the fast Fourier transform on the primary tactile signal, and then the frequency component having the maximum signal amplitude in the spectrum information of the primary tactile signal is determined as the target frequency corresponding to the primary tactile signal to accurately determine the target frequency corresponding to the primary tactile signal.

How to determine a target signal amplitude of the primary tactile signal is described below in detail.

Optionally, before the determining, according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block, the method further includes:
determining, by the encoding end for each primary tactile signal in each first signal block, a signal amplitude of the primary tactile signal at initial occurrence time as the target signal amplitude corresponding to the primary tactile signal; or,
determining, by the encoding end, a highest signal amplitude of the primary tactile signal in the first signal block as the target signal amplitude corresponding to the primary tactile signal.

An optional implementation is that a signal amplitude of the primary tactile signal at the initial occurrence time is obtained, and the signal amplitude is determined as the target signal amplitude.

Another optional implementation is that a highest signal amplitude of the primary tactile signal is obtained, and the signal amplitude is determined as the target signal amplitude.

How to determine the primary tactile signal in the first signal block is described below in detail.

Optionally, before the determining, according to spatial information of the N first tactile signals, a target signal amplitude corresponding to a primary tactile signal in each first signal block, and a target frequency corresponding to the primary tactile signal in each first signal block, at least one temporal-spatial masking threshold matrix corresponding to each first signal block, the method further includes:
calculating, for each first signal block, an average value of signal strength of the N first tactile signals in the first signal block; and
determining the primary tactile signal in the first signal block according to the average value.

In this embodiment, for each first signal block, the average value of the signal strength of the N first tactile signals included in the first signal block is calculated. Specifically, the signal strength of each first tactile signal included in the first signal block is calculated, the signal strength of each first tactile signal is summed, and a summation result is divided by N to obtain the average value. Then, the primary tactile signal in the first signal block is determined according to the average value. In the technical solution, how to calculate the signal strength of the tactile signal has been described, and details are not described herein again.

Optionally, the determining the primary tactile signal in the first signal block according to the average value includes at least one of the following:
determining, in a case that a difference between a maximum value of the signal strength of the N first tactile signals and the average value is less than a preset threshold, a first tactile signal associated with a preset spatial position in the N first tactile signals as the primary tactile signal in the first signal block; and
determining, in a case that a difference between a maximum value of the signal strength of the N first tactile signals and the average value is greater than or equal to a preset threshold, the primary tactile signal in the first signal block according to the signal strength of each of the N first tactile signals.

In this embodiment, the primary tactile signal in the first signal block may be determined according to a magnitude relationship between the maximum value of the signal strength of the N first tactile signals and the average value.

An optional implementation is that: in a case that the difference between the maximum value of the signal strength of the N first tactile signals and the average value is less than the preset threshold, the signal strength of each first tactile signal is approximately the same, and the first tactile signal associated with the preset spatial position is determined as the primary tactile signal in the first signal block. It is to be understood that the preset spatial position is a tactilely sensitive point of a human body, and the tactilely sensitive point is obtained through a subjective test.

Another optional implementation is that: in a case that the difference between the maximum value of the signal strength of the N first tactile signals and the average value is greater than or equal to the preset threshold, there is a relatively large difference between the signal strength of all first tactile signals, and the primary tactile signal in the first signal block is determined according to the signal strength of each of the N first tactile signals. Specifically, the N first tactile signals may be ranked in descending order of the signal strength, and at least one first tactile signal ranked higher is determined as the primary tactile signal.

Another optional implementation is that: in a case that the difference between the maximum value of the signal strength of the N first tactile signals and the average value is less than the preset threshold, the first tactile signal associated with the preset spatial position is determined as the primary tactile signal in the first signal block. In a case that the difference between the maximum value of the signal strength of the N first tactile signals and the average value is greater than or equal to the preset threshold, the primary tactile signal in the first signal block is determined according to the signal strength of each of the N first tactile signals.

In this embodiment, the primary tactile signal in the first signal block is accurately determined by comparing the magnitude relationship between the maximum value of the signal strength of the N first tactile signals and the average value.

In other embodiments, the primary tactile signal in the first signal block may be determined by calculating the magnitude relationship between the signal strength of each first tactile signal and the average value.

Specifically, the difference between the signal strength of each first tactile signal and the average value is calculated to obtain N differences. If there is a difference less than the preset threshold in the N differences, the signal strength of each first tactile signal is approximately the same, and the first tactile signal associated with the preset spatial position is determined as the primary tactile signal in the first signal block. If there is no difference less than the preset threshold in the N differences, there is a relatively large difference between the signal strength of all first tactile signal, and the primary tactile signal in the first signal block is determined according to the signal strength of each of the N first tactile signals.

Optionally, the temporal-spatial masking threshold matrix includes a masking threshold corresponding to each secondary tactile signal, and the filtering out, based on the temporal-spatial masking threshold matrix corresponding to each first signal block, part secondary tactile signals included in each first signal block includes:

filtering out, for each first signal block, a secondary tactile signal that is in the first signal block and whose signal strength is less than a corresponding masking threshold.

In this embodiment, for each first signal block, all secondary tactile signals that are in the first signal block and whose signal strength is less than the corresponding masking threshold are affected by the masking effect generated by the primary tactile signal and are difficult to be sensed by a human body. Therefore, the secondary tactile signals may be determined as redundant signals, and the redundant signals are set to zero to filter out the secondary tactile signals, thereby reducing information redundancy of a target bitstream obtained by encoding, and improving encoding efficiency.

Optionally, the method further includes:
generating, according to first information, first metadata information associated with the target bitstream.

The first metadata information is alternatively referred to as Metadata information. The first metadata information includes spatial information of N second tactile signals. Optionally, the first metadata information may further include at least one of mask information associated with each primary tactile signal or model information associated with each primary tactile signal.

As described above, the spatial information of the N second tactile signals includes, but is not limited to, information of a human body area to which the second tactile signals belong, position information of the human body area to which the second tactile signals belong, and relative position information between the second tactile signals. The mask information includes, but is not limited to, a position number of the primary tactile signal and a spatial pattern mask corresponding to the primary tactile signal. The model information includes, but is not limited to, other information such as a spatial psychohaptic masking model and a sampling rate of a tactile signal.

In an embodiment, the first metadata information includes spatial information of the N second tactile signals, mask information associated with each primary tactile signal, and model information associated with each primary tactile signal. Specifically, the encoding end obtains the spatial information of the N second tactile signals, and obtains the mask information associated with each primary tactile signal and the model information associated with each primary tactile signal that are generated in the encoding process to generate the first metadata information.

In this embodiment, the encoding end generates, according to the first information, the first metadata information associated with the target bitstream, and then a tactile signal may be accurately transmitted to a corresponding human body area by using a vibration tactile reproduction device after the target bitstream is subsequently decoded, thereby implementing accurate reproduction of the tactile signal.

Optionally, the method further includes:
obtaining third information;
generating second metadata information according to the third information; and
encoding the second metadata information to generate a first metadata information packet.

The third information includes spatial information of K third tactile signals, or includes spatial information of K third tactile signals and fourth information, and K is a positive integer greater than 1; and
the fourth information includes at least one of the following:
mask information associated with each primary tactile signal in the K third tactile signals; and
model information associated with each primary tactile signal in the K third tactile signals.

It is to be understood that the spatial information of the K third tactile signals includes, but is not limited to, information of a human body area to which the third tactile signals belong, position information of the human body area to which the third tactile signals belong, and relative position information between the third tactile signals. The mask information includes, but is not limited to, a position number of the primary tactile signal and a spatial pattern mask corresponding to the primary tactile signal. The model information includes, but is not limited to, other information such as a spatial psychohaptic masking model and a sampling rate of a tactile signal.

An optional implementation is that, an encoding end encodes the second metadata information, and separately transmits the generated first metadata information packet to a decoding end. Another optional implementation is that, an encoding end encodes the second metadata information, and transmits the generated first metadata information packet to a decoding end in a bitstream form.

In this embodiment, the encoding end generates the second metadata information according to the third information, and then a tactile signal may be accurately transmitted to a corresponding human body area by using a vibration tactile reproduction device after the target bitstream is subsequently decoded, thereby implementing accurate reproduction of the tactile signal.

Optionally, the filtering out, based on the temporal-spatial masking threshold matrix corresponding to each first signal block, part secondary tactile signals included in each first signal block includes:
filtering out, for a secondary tactile signal that is in each first signal block and whose signal strength is less than a corresponding masking threshold, the secondary tactile signal in a case that an amplitude of the secondary tactile signal is equal to 0, and generating a first flag bit representing the secondary tactile signal; or,
filtering out the secondary tactile signal in a case that an amplitude of the secondary tactile signal is not equal to 0, and generating a proportionality coefficient and a second flag bit representing the secondary tactile signal.

In this embodiment, for the secondary tactile signal that is in each first signal block, whose signal strength is less than a corresponding masking threshold, and whose amplitude is 0, the secondary tactile signal is filtered out, and the first flag bit representing the secondary tactile signal is generated. For the secondary tactile signal that is in each first signal block, whose signal strength is less than a corresponding masking threshold, and whose amplitude is not 0, the secondary tactile signal is filtered out, and a proportionality coefficient and a second flag bit representing the secondary tactile signal are generated. For a specific manner for determining the proportionality coefficient, please refer to subsequent embodiments.

In this embodiment, the secondary tactile signal affected by the masking effect in the first signal block is filtered out to reduce information redundancy of the target bitstream obtained by encoding, thereby improving encoding efficiency.

Optionally, the proportionality coefficient is a ratio of a first value to a second value, the first value is an average amplitude of the primary tactile signal included in the first signal block, and the second value is an average amplitude of the secondary tactile signal that is included in the first signal block and whose signal strength is less than a corresponding masking threshold; or,
the proportionality coefficient is a ratio of a third value to a fourth value, the third value is an average amplitude of the primary tactile signal included in the N first tactile signals, and the fourth value is an average amplitude of the secondary tactile signal that is included in the N first tactile signal and whose signal strength is less than a corresponding masking threshold.

It is to be understood that the secondary tactile signal whose signal strength is less than the corresponding masking threshold may be used as a redundant secondary tactile signal.

An optional implementation is that different proportionality coefficients are used for each first signal block. In this implementation, the proportionality coefficient corresponding to each first signal block is a ratio of an average amplitude of the primary tactile signal included in the first signal block to an average amplitude of a redundant secondary tactile signal included in the first signal block.

Another optional implementation is that the same proportionality coefficient is used for each first signal block. In this implementation, the proportionality coefficient corresponding to each first signal block is a ratio of an average amplitude of the primary tactile signals included in the N first tactile signals to an average amplitude of a redundant secondary tactile signals included in the N first tactile signals.

Optionally, the method further includes:
generating, according to fifth information, third metadata information associated with the target bitstream; and
encoding the third metadata information to generate a second metadata information packet.

The fifth information includes spatial information of the N second tactile signals, second flag bits of at least part secondary tactile signals in the N second tactile signals, and proportionality coefficients of the at least part secondary tactile signals in the N second tactile signals, or includes spatial information of the N second tactile signals, second flag bits of at least part secondary tactile signals in the N second tactile signals, and proportionality coefficients of the at least part secondary tactile signals in the N second tactile signals and sixth information; and
the sixth information includes at least one of the following:
mask information associated with each primary tactile signal; and
model information associated with each primary tactile signal.

As described above, the secondary tactile signal whose signal strength is less than the corresponding masking threshold is alternatively referred to as the redundant secondary tactile signal. For the redundant secondary tactile signal whose amplitude is not 0, the second flag bit of the redundant secondary tactile signal represents that the decoding end needs to recover the secondary tactile signal.

In this embodiment, the encoding end generates the third metadata information according to the fifth information, and then part of the secondary tactile signals may be recovered at the decoding end after the target bitstream is decoded subsequently, thereby implementing accurate reproduction of the tactile signal.

FIG. 4 is a flowchart of a tactile signal decoding method according to an embodiment of this application. The tactile signal decoding method according to this embodiment of this application includes the following steps:
S401: A decoding end obtains a first metadata information packet.

S402: The decoding end decodes the first metadata information packet to obtain second metadata information.

S403: The decoding end parses the second metadata information to obtain third information.

In this embodiment, the decoding end obtains the first metadata information packet transmitted by an encoding end, decodes the first metadata information packet to obtain the second metadata information, and parses the second metadata information to obtain the third information.

The third information includes spatial information of K third tactile signals, or includes spatial information of K third tactile signals and fourth information, and K is a positive integer greater than 1; and
the fourth information includes at least one of the following:
mask information associated with each primary tactile signal in the K third tactile signals; and
model information associated with each primary tactile signal in the K third tactile signals.

It is to be understood that the decoding end decodes the obtained target bitstream to obtain reconstructed K third tactile signals. The third information is obtained according to a decoding result of the first metadata information packet, and then a human body area corresponding to each third tactile signal is determined according to the spatial information in the third information. Subsequently, the third tactile signal is transmitted to the corresponding human body area by using a vibration tactile reproduction device, thereby implementing reproduction of a tactile signal.

In a case that the vibration tactile reproduction device is limited by a processing capability of the device, a primary tactile signal in the K third tactile signals needs to be reconstructed preferentially. In this case, the encoding end may add identifier information to the primary tactile signal in the K third tactile signals. The decoding end preferentially processes the third tactile signal associated with the identifier information to ensure high-quality recovery of all reconstructed third tactile signals.

Optionally, the method further includes:
obtaining a second metadata information packet;
decoding the second metadata information packet to obtain third metadata information;
parsing the third metadata information to obtain fifth information; and
recovering, based on the fifth information and a primary tactile signal in N second tactile signals obtained by decoding, at least part secondary tactile signals whose corresponding flag bits are second flag bits in the N second tactile signals.

The fifth information includes spatial information of the N second tactile signals, second flag bits of at least part secondary tactile signals in the N second tactile signals, and proportionality coefficients of the at least part secondary tactile signals in the N second tactile signals, or includes spatial information of the N second tactile signals, second flag bits of at least part secondary tactile signals in the N second tactile signals, and proportionality coefficients of the at least part secondary tactile signals in the N second tactile signals and sixth information; and
the sixth information includes at least one of the following:
mask information associated with each primary tactile signal; and
model information associated with each primary tactile signal.

In this embodiment, the decoding end decodes the obtained target bitstream to obtain the primary tactile signal in the reconstructed N second tactile signals. The fifth information is obtained according to a decoding result of the second metadata information packet, and then a to-be-recovered secondary tactile signal is determined according to the second flag bit in the fifth information, and the secondary tactile signal represented by the second flag bit is recovered according to a proportionality coefficient in the fifth information, thereby implementing reproduction of a tactile signal.

Optionally, the recovering at least part secondary tactile signals in the N second tactile signals based on the fifth information and a primary tactile signal in the N second tactile signals obtained by decoding includes:
calculating a multiplication result between an amplitude of the primary tactile signal in the N second tactile signals and a fifth value, where the fifth value is a product of the masking threshold coefficient represented by the model information and the proportionality coefficient; and
recovering the at least part secondary tactile signals in the N second tactile signals according to the multiplication result.

In this embodiment, the amplitude of the secondary tactile signal represented by the second flag bit may be set as a product of the multiplication result and the amplitude of the primary tactile signal obtained by decoding to recover the secondary tactile signal.

For example, if the masking threshold coefficient represented by the model information is 0.5, and the proportionality coefficient is 0.8, the amplitude of the secondary tactile signal may be set as 0.4 times the amplitude of the primary tactile signal.

The tactile signal encoding method according to the embodiments of this application may be performed by a tactile signal encoding apparatus. In the embodiments of this application, the tactile signal encoding apparatus according to the embodiments of this application is described by using an example in which the tactile signal encoding apparatus is applied to an encoding end to perform the tactile signal encoding method.

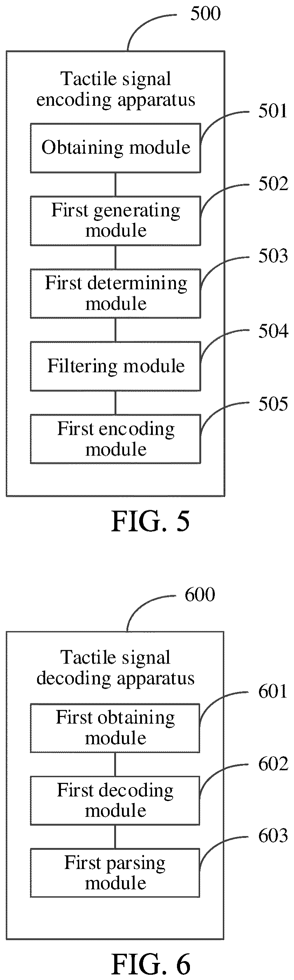

As shown in FIG. 5, embodiments of this application provide a tactile signal encoding apparatus 500, including:
an obtaining module 501, configured to obtain N first tactile signals, where N is a positive integer greater than 1;
a first generating module 502, configured to generate M first signal blocks according to the N first tactile signals, where the first signal block includes part signal sources of the N first tactile signals, and M is a positive integer greater than 1;
a first determining module 503, configured to determine, according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block, where the first signal block includes the primary tactile signal and a secondary tactile signal;
a filtering module 504, configured to filter out, based on the temporal-spatial masking threshold matrix corresponding to each first signal block, part secondary tactile signals included in each first signal block to obtain M second signal blocks; and
a first encoding module 505, configured to encode the N second tactile signals to generate a target bitstream, where the N second tactile signals are obtained based on a concatenation operation performed on the M second signal blocks.

Optionally, the first signal block includes at least one primary tactile signal and at least one secondary tactile signal associated with the primary tactile signal; and
the first determining module 503 is specifically configured to:
generate, for each first signal block, a spatial pattern mask associated with each primary tactile signal based on a relative position between each primary tactile signal represented by the spatial information and the at least one secondary tactile signal associated with each primary tactile signal, where the spatial pattern mask is used for representing a spatial position relationship between an associated primary tactile signal and the at least one secondary tactile signal associated with the primary tactile signal;
determine, according to the spatial pattern mask associated with each primary tactile signal and the spatial information, a psychohaptic masking model associated with each primary tactile signal, where each psychohaptic masking model includes at least one masking threshold coefficient, the masking threshold coefficient is associated with a spatial position of the secondary tactile signal, and the masking threshold coefficient is determined based on a target frequency corresponding to the associated primary tactile signal;
determine, according to the target signal amplitude corresponding to each primary tactile signal and each masking threshold coefficient included in the psychohaptic masking model associated with each primary tactile signal, a spatial masking threshold matrix corresponding to each primary tactile signal, where each spatial threshold matrix includes at least one masking threshold, the masking threshold is in a mapping correspondence with the secondary tactile signal, and the masking threshold is used for representing a masking effect of the primary tactile signal on the secondary tactile signal; and
obtain, according to the spatial masking threshold matrix corresponding to each primary tactile signal, at least one temporal-spatial masking threshold matrix corresponding to the first signal block.

Optionally, the first determining module 503 is further specifically configured to:
perform a multiplication operation on the target signal amplitude corresponding to each primary tactile signal and each masking threshold coefficient included in the psychohaptic masking model associated with each primary tactile signal to obtain the spatial masking threshold matrix corresponding to each primary tactile signal.

Optionally, the first determining module 503 is further specifically configured to:
obtain, in descending order of signal strength of all primary tactile signals and sequentially according to the spatial masking threshold matrix corresponding to each primary tactile signal, at least one temporal-spatial masking threshold matrix corresponding to the first signal block.

Optionally, the first determining module 503 is further specifically configured to:
assign, for each primary tactile signal, at least one masking threshold at each target position in the spatial masking threshold matrix corresponding to the primary tactile signal to obtain a temporal-spatial masking threshold matrix corresponding to the primary tactile signal, where
the target position is used for representing a spatial position relationship between a primary tactile signal and a secondary tactile signal, the masking threshold assigned to the target position of the temporal-spatial masking threshold matrix is used for representing a masking effect of the primary tactile signal on the secondary tactile signal within an impact time period, and the impact time period is associated with a length of the first signal block.

Optionally, the first generating module 502 is specifically configured to:
perform low-pass filtering processing on the N first tactile signals; and
partition, by using occurrence time corresponding to the N first tactile signals obtained after the low-pass filtering processing as partitioning points, the N first tactile signals obtained after the low-pass filtering processing to generate M first signal blocks, where
initial time corresponding to each first tactile signal belonging to the same first signal block is the same.

Optionally, the tactile signal encoding apparatus 500 further includes:
a processing module, configured to perform fast Fourier transform on the primary tactile signal in each first signal block to obtain spectrum information of each primary tactile signal; and
a second determining module, configured to determine, for each primary tactile signal, a highest frequency represented by the spectrum information of the primary tactile signal as the target frequency corresponding to the primary tactile signal.

Optionally, the tactile signal encoding apparatus 500 further includes:
a third determining module, configured to determine, for each primary tactile signal in each first signal block, a signal amplitude of the primary tactile signal at initial occurrence time as the target signal amplitude corresponding to the primary tactile signal; or,
a fourth determining module, configured to determine a highest signal amplitude of the primary tactile signal as the target signal amplitude corresponding to the primary tactile signal.

Optionally, the tactile signal encoding apparatus 500 further includes:
a calculating module, configured to calculate, for each first signal block, an average value of signal strength of N first tactile signals in the first signal block; and
a fifth determining module, configured to determine the primary tactile signal in the first signal block according to the average value.

Optionally, the fifth determining module is further specifically configured to perform at least one of the following:
determining, in a case that a difference between a maximum value of the signal strength of the N first tactile signals and the average value is less than a preset threshold, a first tactile signal associated with a preset spatial position in the N first tactile signals as the primary tactile signal in the first signal block; and
determining, in a case that a difference between a maximum value of the signal strength of the N first tactile signals and the average value is greater than or equal to a preset threshold, the primary tactile signal in the first signal block according to the signal strength of each of the N first tactile signals.

Optionally, the temporal-spatial masking threshold matrix includes a masking threshold corresponding to each secondary tactile signal, and the filtering module 504 is specifically configured to:
filter out, for each first signal block, a secondary tactile signal that is in the first signal block and whose signal strength is less than a corresponding masking threshold.

Optionally, the tactile signal encoding apparatus 500 further includes:
a second generating module, configured to generating, according to first information, first metadata information associated with the target bitstream, where
the first information includes spatial information of the N second tactile signals, or includes spatial information of the N second tactile signals and second information; and
the second information includes at least one of the following:
   mask information associated with each primary tactile signal; and
   model information associated with each primary tactile signal.

Optionally, the temporal-spatial masking threshold matrix that corresponds to each first signal block and that is within the same impact time period is the same, and the impact time period is associated with the length of the first signal block.

Optionally, the tactile signal encoding apparatus 500 further includes:
an obtaining module, configured to obtain third information;
a third generating module, configured to generate second metadata information according to the third information; and
a second encoding module, configured to encode the second metadata information to generate a first metadata information packet, where
the third information includes spatial information of K third tactile signals, or includes spatial information of K third tactile signals and fourth information, and K is a positive integer greater than 1; and
the fourth information includes at least one of the following:
   mask information associated with each primary tactile signal in the K third tactile signals; and
   model information associated with each primary tactile signal in the K third tactile signals.

Optionally, the filtering module 504 is further specifically configured to:
filter out, for a secondary tactile signal that is in each first signal block and whose signal strength is less than a corresponding masking threshold, the secondary tactile signal in a case that an amplitude of the secondary tactile signal is equal to 0, and generate a first flag bit representing the secondary tactile signal; or,
filter out the secondary tactile signal in a case that an amplitude of the secondary tactile signal is not equal to 0, and generate a proportionality coefficient and a second flag bit representing the secondary tactile signal.

Optionally, the proportionality coefficient is a ratio of a first value to a second value, the first value is an average amplitude of the primary tactile signal included in the first signal block, and the second value is an average amplitude of the secondary tactile signal that is included in the first signal block and whose signal strength is less than a corresponding masking threshold; or,
the proportionality coefficient is a ratio of a third value to a fourth value, the third value is an average amplitude of the primary tactile signal included in the N first tactile signals, and the fourth value is an average amplitude of the secondary tactile signal that is included in the N first tactile signal and whose signal strength is less than a corresponding masking threshold.

Optionally, the tactile signal encoding apparatus 500 further includes:
a fourth generating module, configured to generate, according to fifth information, third metadata information associated with the target bitstream; and
a third encoding module, configured to encode the third metadata information to generate a second metadata information packet, where
the fifth information includes spatial information of the N second tactile signals, second flag bits of at least part secondary tactile signals in the N second tactile signals, and proportionality coefficients of the at least part secondary tactile signals in the N second tactile signals, or includes spatial information of the N second tactile signals, second flag bits of at least part secondary tactile signals in the N second tactile signals, and proportionality coefficients of the at least part secondary tactile signals in the N second tactile signals and sixth information; and
the sixth information includes at least one of the following:
   mask information associated with each primary tactile signal; and
   model information associated with each primary tactile signal.

In this embodiment of this application, N first tactile signals are obtained; M first signal blocks are generated according to the N first tactile signals; a temporal-spatial masking threshold matrix corresponding to each first signal block is determined according to spatial information of the N first tactile signals, a target signal amplitude corresponding to a primary tactile signal in each first signal block, and a target frequency corresponding to the primary tactile signal in each first signal block; part secondary tactile signals included in each first signal block are filtered out based on the temporal-spatial masking threshold matrix corresponding to each first signal block to obtain M second signal blocks; and the N second tactile signals are encoded to generate a target bitstream. Compared with a to-be-coded tactile signal in a related technology, in this embodiment of this application, a temporal-spatial masking threshold matrix is determined according to spatial information of a tactile signal, a target signal amplitude corresponding to each primary tactile signal, and a target frequency corresponding to a primary tactile signal in each first signal block, and then redundant secondary tactile signals are filtered out through the temporal-spatial masking threshold matrix. In this way, mutual masking effects of the tactile signal in time and space are considered during encoding, thereby reducing information redundancy of the target bitstream obtained by encoding, and improving encoding efficiency.

The tactile signal decoding method according to the embodiments of this application may be performed by a tactile signal decoding apparatus. In the embodiments of this application, the tactile signal decoding apparatus according to the embodiments of this application is described by using an example in which the tactile signal decoding apparatus is applied to an encoding end to perform the tactile signal decoding method.

As shown in FIG. 6, embodiments of this application further provide a tactile signal decoding apparatus 600, including:
a first obtaining module 601, configured to obtain a first metadata information packet;
a first decoding module 602, configured to decode the first metadata information packet to obtain second metadata information; and
a first parsing module 603, configured to parse the second metadata information to obtain third information, where
the third information includes spatial information of K third tactile signals, or includes spatial information of K third tactile signals and fourth information, and K is a positive integer greater than 1; and
the fourth information includes at least one of the following:
   mask information associated with each primary tactile signal in the K third tactile signals; and
   model information associated with each primary tactile signal in the K third tactile signals.

Optionally, the tactile signal decoding apparatus 600 further includes:
a second obtaining module, configured to obtain second metadata information packet;
a second decoding module, configured to decode the second metadata information packet to obtain third metadata information;
a second parsing module, configured to parse the third metadata information to obtain fifth information; and
a recovering module, configured to recover, based on the fifth information and a primary tactile signal in N second tactile signals obtained by decoding, at least part secondary tactile signals whose corresponding flag bits are second flag bits in the N second tactile signals, where
the fifth information includes spatial information of the N second tactile signals, second flag bits of at least part secondary tactile signals in the N second tactile signals, and proportionality coefficients of the at least part secondary tactile signals in the N second tactile signals, or includes spatial information of the N second tactile signals, second flag bits of at least part secondary tactile signals in the N second tactile signals, and proportionality coefficients of the at least part secondary tactile signals in the N second tactile signals and sixth information; and
the sixth information includes at least one of the following:
   mask information associated with each primary tactile signal; and
   model information associated with each primary tactile signal.

Optionally, the recovering module is specifically configured to:
calculate a multiplication result between an amplitude of the primary tactile signal in the N second tactile signals and a fifth value, where the fifth value is a product of the masking threshold coefficient represented by the model information and the proportionality coefficient; and
recover the at least part secondary tactile signals in the N second tactile signals according to the multiplication result.

The tactile signal encoding apparatus applied to an encoding end according to the embodiments of this application can implement processes implemented in a method embodiment in FIG. 1, and achieve the same technical effects. To avoid repetition, details are not described herein again.

The tactile signal decoding apparatus applied to a decoding end according to the embodiments of this application can implement processes implemented in a method embodiment in FIG. 4, and achieve the same technical effects. To avoid repetition, details are not described herein again.

The tactile signal encoding apparatus or the tactile signal decoding apparatus in the embodiments of this application may be an electronic device, for example, an electronic device having an operating system, or may be a component in an electronic device, for example, an integrated circuit or a chip. The electronic device may be a terminal, or may be another device other than a terminal. For example, the terminal may include, but is not limited to the types of terminals listed above, and the another device may be a server, a network attached storage (Network Attached Storage, NAS), or the like. This is not specifically limited in the embodiments of this application.

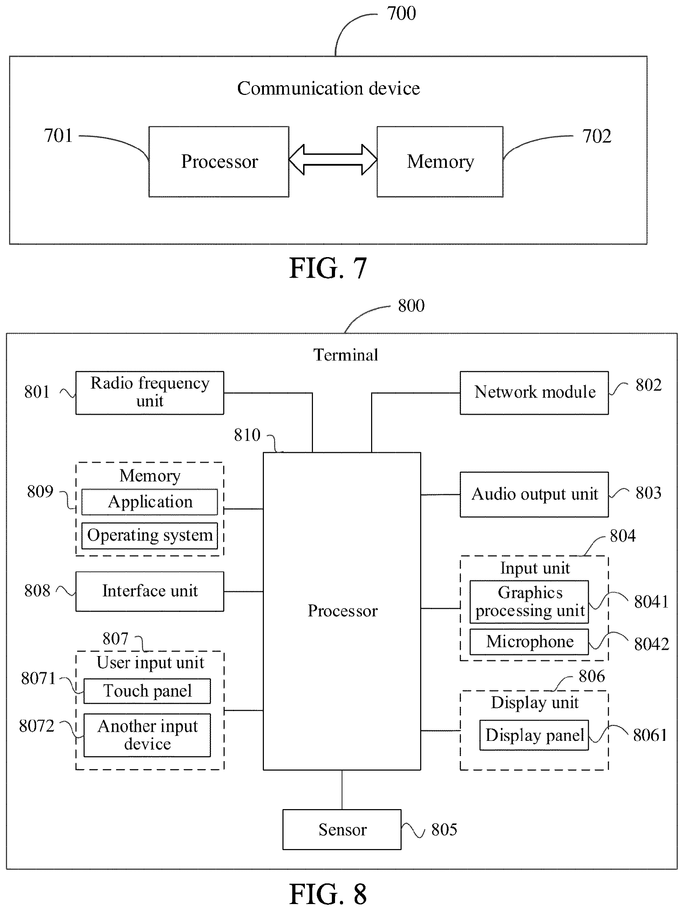

Optionally, as shown in FIG. 7, embodiments of this application further provide a communication device 700, including a processor 701 and a memory 702. The memory 702 stores a program or instructions executable on the processor 701. For example, when the communication device 700 is a terminal, the program or instructions implement the following operations when executed by the processor 701:
obtaining N first tactile signals;
generating M first signal blocks according to the N first tactile signals;
determining, according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block;
filtering out, based on the temporal-spatial masking threshold matrix corresponding to each first signal block, part secondary tactile signals included in each first signal block to obtain M second signal blocks;
performing a concatenation operation on the M second signal blocks to obtain N second tactile signals; and
encoding the N second tactile signals to generate a target bitstream.

Or, the program or instructions further implement the following operations when executed by the processor 701:
obtaining, by a decoding end, a first metadata information packet;
decoding, by the decoding end, the first metadata information packet to obtain second metadata information; and
parsing, by the decoding end, the second metadata information to obtain third information.

The communication device embodiment corresponds to the method embodiment. Implementation processes and implementations of the method embodiment are applicable to the communication device embodiment, and can achieve the same technical effect.

Embodiments of this application further provide a terminal. Specifically, FIG. 8 is a schematic diagram of a hardware structure for implementing a terminal according to an embodiment of this application.

The terminal 800 includes, but is not limited to: components such as a radio frequency unit 801, a network module 802, an audio output unit 803, an input unit 804, a sensor 805, a display unit 806, a user input unit 807, an interface unit 808, a memory 809, and a processor 810.

Those skilled in the art may understand that the terminal 800 may further include a power supply (for example, a battery) for supplying power to the components. The power supply may be logically connected to the processor 810 through a power management system, thereby realizing functions such as charging management, discharging management, and power consumption management through the power management system. A terminal structure shown in FIG. 8 does not constitute a limitation to the terminal. The terminal may include more or fewer components than those shown in the figure, or combine some components, or have different component arrangements. Details are not described herein again.

It is to be understood that in an embodiment of this application, the input unit 804 may include a graphics processing unit (Graphics Processing Unit, GPU) 8041 and a microphone 8042. The graphics processing unit 8041 processes image data of static pictures or videos captured by an image capture apparatus (for example, a camera) in a video capture mode or an image capture mode. The display unit 806 may include a display panel 8061. The display panel 8061 may be configured in a form of a liquid crystal display, an organic light-emitting diode, or the like. The user input unit 807 includes at least one of a touch panel 8071 and another input device 8072. The touch panel 8071 is alternatively referred to as a touchscreen. The touch panel 8071 may include two parts: a touch detection apparatus and a touch controller. Another input device 8072 may include, but is not limited to, a physical keyboard, a functional key (such as a volume control key or a switch key), a track ball, a mouse, and a joystick. Details are not described herein again.

In embodiments of this application, after receiving downlink data from a network side device, the radio frequency unit 801 may transmit the downlink data to the processor 810 for processing. The radio frequency unit 801 may send uplink data to the network side device. Generally, the radio frequency unit 801 includes, but is not limited to, an antenna, an amplifier, a transceiver, a coupler, a low noise amplifier, a duplexer, and the like.

The memory 809 may be configured to store a software program or instructions and various types of data. The memory 809 may mainly include a first storage area storing a program or instructions and a second storage area storing data. The first storage area may store an operating system, an application or instructions required by at least one function (for example, a sound playback function and an image display function), and the like. In addition, the memory 809 may include a volatile memory or a nonvolatile memory. The non-volatile memory may be a read-only memory (Read-Only Memory, ROM), a programmable read-only memory (Programmable ROM, PROM), an erasable programmable read-only memory (Erasable PROM, EPROM), an electrically erasable programmable read-only memory (Electrically EPROM, EEPROM), or a flash memory. The volatile memory may be a random access memory (Random Access Memory, RAM), a static random access memory (Static RAM, SRAM), a dynamic random access memory (Dynamic RAM, DRAM), a synchronous dynamic random access memory (Synchronous DRAM, SDRAM), a double data rate synchronous dynamic random access memory (Double Data Rate SDRAM, DDR SDRAM), an enhanced synchronous dynamic random access memory (Enhanced SDRAM, ESDRAM), a synchronous link dynamic random access memory (Synch link DRAM, SLDRAM), or a direct rambus random access memory (Direct Rambus RAM, DR RAM). The memory 809 in the embodiments of this application includes, but is not limited to, these and any other suitable types of memories.

The processor 810 may include one or more processing units. Optionally, the processor 810 integrates an application processor and a modulation and demodulation processor. The application processor mainly processes operations related to an operating system, a user interface, an application program, and the like. The modulation and demodulation processor mainly processes a wireless communication signal, for example, a baseband processor. It may be understood that the modulation and demodulation processor may alternatively not be integrated into the processor 810.

The processor 810 is configured to perform the following operations:
obtaining N first tactile signals;
generating M first signal blocks according to the N first tactile signals;
determining, according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block;
filtering out, based on the temporal-spatial masking threshold matrix corresponding to each first signal block, part secondary tactile signals included in each first signal block to obtain M second signal blocks;
performing a concatenation operation on the M second signal blocks to obtain N second tactile signals; and
encoding N second tactile signals to generate a target bitstream.

Or, the processor 810 is configured to perform the following operations:
obtaining a first metadata information packet;
decoding the first metadata information packet to obtain second metadata information; and
parsing the second metadata information to obtain third information.

Embodiments of this application further provide a readable storage medium. The readable storage medium stores a program or instructions. The program or instructions implements processes of the tactile signal encoding method, or implements processes of the tactile signal decoding method when executed by a processor, and can achieve the same technical effect. To avoid repetition, details are not described herein again.

The processor is a processor in the terminal in the embodiments. The readable storage medium includes a computer-readable storage medium, for example, a computer read only memory ROM, a random-access memory RAM, a magnetic disk, or an optical disk. In some examples, the readable storage medium may be a non-volatile readable storage medium,

Embodiments of this application further provide a chip. The chip includes a processor and a communication interface. The communication interface is coupled to the processor. The processor is configured to run a program or instructions to implement processes of the tactile signal encoding method in the embodiments or processes of the tactile signal decoding method in the embodiments, and can achieve the same technical effect. To avoid repetition, details are not described herein again.

It is to be understood that the chip mentioned in this embodiment of this application may alternatively be referred to as a system level chip, a system chip, a chip system, a system-on-a-chip, and the like.

Embodiments of this application further provide a computer program/program product. The computer program/program product is stored in a storage medium. The computer program/program product implements processes of the tactile signal encoding method in the embodiments or processes of the tactile signal decoding method in the embodiments when executed by at least one processor, and can achieve the same technical effect. To avoid repetition, details are not described herein again.

Embodiments of this application further provide a system. The system includes an encoding end and a decoding end. The encoding end performs processes of the tactile signal encoding method applied to the encoding end, the decoding end performs processes of the tactile signal decoding method applied to the decoding end, and can achieve the same technical effect. To avoid repetition, details are not described herein again.

It is to be noted that, herein, terms "include", "comprise", or any other variation thereof herein are intended to cover a non-exclusive inclusion, such that a process, method, article or apparatus including a series of elements not only includes those elements, but also includes other elements that are not explicitly listed, or includes elements inherent to such a process, method, article or apparatus. Without more limitations, elements defined by the sentence "including one" does not exclude that there are other same elements in the process, the method, the article, or the apparatus. In addition, it is to be noted that scopes of the methods and apparatuses in implementations of this application are not limited to performing functions in an order shown or discussed, but may alternatively include performing the functions in a substantially simultaneous manner or in a reverse order according to the functions involved. For example, the described methods may be implemented in an order different from that described, and various steps may be added, omitted, or combined. In addition, features described with reference to some examples may alternatively be combined in other examples.

Through the description of the above implementations, those skilled in the art can clearly understand that the embodiment method may be implemented by means of computer software and a necessary general hardware platform, and certainly, may alternatively be implemented through hardware. The computer software product is stored in a storage medium (such as a ROM, a RAM, a magnetic disk, and a compact disk), including several instructions to enable a terminal (or a network device) to perform the method in the embodiments of this application.

Embodiments of this application have been described above with reference to accompanying drawings. However, this application is not limited to the specific implementations. The specific embodiments are merely examples rather than restrictions. Those of ordinary skill in the art may make implementations in many forms under the teaching of this application without departing from the spirit of this application and the scope of protection of claims. These implementations all fall within the scope of protection of this application.

## Claims

1. A tactile signal encoding method, comprising:
obtaining, by an encoding end, N first tactile signals, wherein N is a positive integer greater than 1;
generating, by the encoding end, M first signal blocks according to the N first tactile signals, wherein the first signal block comprises part signal sources of the N first tactile signals, and M is a positive integer greater than 1;
determining, by the encoding end according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block, wherein the first signal block comprises the primary tactile signal and a secondary tactile signal;
filtering out, by the encoding end based on the temporal-spatial masking threshold matrix corresponding to each first signal block, part secondary tactile signals comprised in each first signal block to obtain M second signal blocks; and
encoding, by the encoding end, N second tactile signals to generate a target bitstream, wherein the N second tactile signals are obtained based on a concatenation operation performed on the M second signal blocks.

2. The method according to claim 1, wherein the first signal block comprises at least one primary tactile signal and at least one secondary tactile signal associated with the primary tactile signal; and
the determining, by the encoding end according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block comprises:
generating, by the encoding end for each first signal block, a spatial pattern mask associated with each primary tactile signal based on a relative position between each primary tactile signal represented by the spatial information and the at least one secondary tactile signal associated with each primary tactile signal, wherein the spatial pattern mask is used for representing a spatial position relationship between an associated primary tactile signal and the at least one secondary tactile signal associated with the primary tactile signal;
determining, by the encoding end according to the spatial pattern mask associated with each primary tactile signal and the spatial information, a psychohaptic masking model associated with each primary tactile signal, wherein each psychohaptic masking model comprises at least one masking threshold coefficient, the masking threshold coefficient is associated with a spatial position of the secondary tactile signal, and the masking threshold coefficient is determined based on a target frequency corresponding to the associated primary tactile signal;
determining, by the encoding end according to the target signal amplitude corresponding to each primary tactile signal and each masking threshold coefficient comprised in the psychohaptic masking model associated with each primary tactile signal, a spatial masking threshold matrix corresponding to each primary tactile signal, wherein each spatial threshold matrix comprises at least one masking threshold, the masking threshold is in a mapping correspondence with the secondary tactile signal, and the masking threshold is used for representing a masking effect of the primary tactile signal on the secondary tactile signal; and
obtaining, by the encoding end according to the spatial masking threshold matrix corresponding to each primary tactile signal, at least one temporal-spatial masking threshold matrix corresponding to the first signal block.

3. The method according to claim 2, wherein determining, according to the target signal amplitude corresponding to each primary tactile signal and each masking threshold coefficient comprised in the psychohaptic masking model associated with each primary tactile signal, a spatial masking threshold matrix corresponding to each primary tactile signal comprises:
performing a multiplication operation on the target signal amplitude corresponding to each primary tactile signal and each masking threshold coefficient comprised in the psychohaptic masking model associated with each primary tactile signal to obtain the spatial masking threshold matrix corresponding to each primary tactile signal.

4. The method according to claim 2, wherein the obtaining, according to the spatial masking threshold matrix corresponding to each primary tactile signal, at least one temporal-spatial masking threshold matrix corresponding to the first signal block comprises:
obtaining, by the encoding end in descending order of signal strength of all primary tactile signals and sequentially according to the spatial masking threshold matrix corresponding to each primary tactile signal, at least one temporal-spatial masking threshold matrix corresponding to the first signal block.

5. The method according to claim 2, wherein the obtaining, according to the spatial masking threshold matrix corresponding to each primary tactile signal, at least one temporal-spatial masking threshold matrix corresponding to the first signal block comprises:
assigning, by the encoding end for each primary tactile signal, at least one masking threshold at each target position in the spatial masking threshold matrix corresponding to the primary tactile signal to obtain a temporal-spatial masking threshold matrix corresponding to the primary tactile signal, wherein
the target position is used for representing a spatial position relationship between a primary tactile signal and a secondary tactile signal, the masking threshold assigned to the target position of the temporal-spatial masking threshold matrix is used for representing a masking effect of the primary tactile signal on the secondary tactile signal within an impact time period, and the impact time period is associated with a length of the first signal block.

6. The method according to any one of claims 1 to 5, wherein the generating M first signal blocks according to the N first tactile signals comprises:
performing, by the encoding end, low-pass filtering processing on the N first tactile signals; and
partitioning, by the encoding end by using occurrence time corresponding to the N first tactile signals obtained after the low-pass filtering processing as partitioning points, the N first tactile signals obtained after the low-pass filtering processing to generate M first signal blocks, wherein
initial time corresponding to each first tactile signal belonging to the same first signal block is the same.

7. The method according to any one of claims 1 to 6, wherein before the determining, according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block, the method further comprises:
performing, by the encoding end, fast Fourier transform on the primary tactile signal in each first signal block to obtain spectrum information of each primary tactile signal; and
determining, by the encoding end for each primary tactile signal, a highest frequency represented by the spectrum information of the primary tactile signal as the target frequency corresponding to the primary tactile signal.

8. The method according to any one of claims 1 to 6, wherein before the determining, according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block, the method further comprises:
determining, by the encoding end for each primary tactile signal in each first signal block, a signal amplitude of the primary tactile signal at initial occurrence time as the target signal amplitude corresponding to the primary tactile signal; or,
determining, by the encoding end, a highest signal amplitude of the primary tactile signal as the target signal amplitude corresponding to the primary tactile signal.

9. The method according to any one of claims 1 to 6, wherein before the determining, according to spatial information of the N first tactile signals, a target signal amplitude corresponding to a primary tactile signal in each first signal block, and a target frequency corresponding to the primary tactile signal in each first signal block, at least one temporal-spatial masking threshold matrix corresponding to each first signal block, the method further comprises:
calculating, by the encoding end for each first signal block, an average value of signal strength of the N first tactile signals in the first signal block; and
determining, by the encoding end, the primary tactile signal in the first signal block according to the average value.

10. The method according to claim 9, wherein the determining the primary tactile signal in the first signal block according to the average value comprises at least one of the following:
determining, by the encoding end in a case that a difference between a maximum value of the signal strength of the N first tactile signals and the average value is less than a preset threshold, a first tactile signal associated with a preset spatial position in the N first tactile signals as the primary tactile signal in the first signal block; and
determining, by the encoding end in a case that a difference between a maximum value of the signal strength of the N first tactile signals and the average value is greater than or equal to a preset threshold, the primary tactile signal in the first signal block according to the signal strength of each of the N first tactile signals.

11. The method according to any one of claims 1 to 10, wherein the temporal-spatial masking threshold matrix comprises a masking threshold corresponding to each secondary tactile signal, and the adjusting, based on the temporal-spatial masking threshold matrix corresponding to each first signal block, part secondary tactile signals comprised in each first signal block comprises:
filtering out, by the encoding end for each first signal block, a secondary tactile signal that is in the first signal block and whose signal strength is less than a corresponding masking threshold.

12. The method according to any one of claims 1 to 11, further comprising:
generating, by the encoding end according to first information, first metadata information associated with the target bitstream, wherein
the first information comprises spatial information of the N second tactile signals, or comprises spatial information of the N second tactile signals and second information; and
the second information comprises at least one of the following:
mask information associated with each primary tactile signal; and
model information associated with each primary tactile signal.

13. The method according to any one of claims 1 to 11, wherein the temporal-spatial masking threshold matrix that corresponds to each first signal block and that is within the same impact time period is the same, and the impact time period is associated with the length of the first signal block.

14. The method according to any one of claims 1 to 13, further comprising:
obtaining, by the encoding end, third information;
obtaining, by the encoding end, second metadata information according to the third information;
encoding, by the encoding end, the second metadata information to generate a first metadata information packet, wherein
the third information comprises spatial information of K third tactile signals, or comprises spatial information of K third tactile signals and fourth information, and K is a positive integer greater than 1; and
the fourth information comprises at least one of the following:
mask information associated with each primary tactile signal in the K third tactile signals; and
model information associated with each primary tactile signal in the K third tactile signals.

15. The method according to any one of claims 1 to 10, wherein the filtering out, based on the temporal-spatial masking threshold matrix corresponding to each first signal block, part secondary tactile signals comprised in each first signal block comprises:
filtering out, by the encoding end for a secondary tactile signal that is in each first signal block and whose signal strength is less than a corresponding masking threshold, the secondary tactile signal in a case that an amplitude of the secondary tactile signal is equal to 0, and generating a first flag bit representing the secondary tactile signal; or,
filtering out, by the encoding end, the secondary tactile signal in a case that an amplitude of the secondary tactile signal is not equal to 0, and generating a proportionality coefficient and a second flag bit representing the secondary tactile signal.

16. The method according to claim 15, wherein the proportionality coefficient is a ratio of a first value to a second value, the first value is an average amplitude of the primary tactile signal comprised in the first signal block, and the second value is an average amplitude of the secondary tactile signal that is comprised in the first signal block and whose signal strength is less than a corresponding masking threshold; or,
the proportionality coefficient is a ratio of a third value to a fourth value, the third value is an average amplitude of the primary tactile signal comprised in the N first tactile signals, and the fourth value is an average amplitude of the secondary tactile signal that is comprised in the N first tactile signal and whose signal strength is less than a corresponding masking threshold.

17. The method according to claim 15 or 16, further comprising:
generating, by the encoding end according to fifth information, third metadata information associated with the target bitstream; and
encoding, by the encoding end, the third metadata information to generate a second metadata information packet, wherein
the fifth information comprises spatial information of the N second tactile signals, second flag bits of at least part secondary tactile signals in the N second tactile signals, and proportionality coefficients of the at least part secondary tactile signals in the N second tactile signals, or comprises spatial information of the N second tactile signals, second flag bits of at least part secondary tactile signals in the N second tactile signals, and proportionality coefficients of the at least part secondary tactile signals in the N second tactile signals and sixth information; and
the sixth information comprises at least one of the following:
mask information associated with each primary tactile signal; and
model information associated with each primary tactile signal.

18. A tactile signal decoding method, comprising:
obtaining, by a decoding end, a first metadata information packet;
decoding, by the decoding end, the first metadata information packet to obtain second metadata information; and
parsing, by the decoding end, the second metadata information to obtain third information, wherein
the third information comprises spatial information of K third tactile signals, or comprises spatial information of K third tactile signals and fourth information, and K is a positive integer greater than 1; and
the fourth information comprises at least one of the following:
mask information associated with each primary tactile signal in the K third tactile signals; and
model information associated with each primary tactile signal in the K third tactile signals.

19. The method according to claim 18, further comprising:
obtaining, by the decoding end, a second metadata information packet;
decoding, by the decoding end, the second metadata information packet to obtain third metadata information;
parsing, by the decoding end, the third metadata information to obtain fifth information; and
recovering, by the decoding end, at least part secondary tactile signals whose corresponding flag bits are second flag bits in the N second tactile signals based on the fifth information and a primary tactile signal in the N second tactile signals obtained by decoding, wherein
the fifth information comprises spatial information of the N second tactile signals, second flag bits of at least part secondary tactile signals in the N second tactile signals, and proportionality coefficients of the at least part secondary tactile signals in the N second tactile signals, or comprises spatial information of the N second tactile signals, second flag bits of at least part secondary tactile signals in the N second tactile signals, and proportionality coefficients of the at least part secondary tactile signals in the N second tactile signals and sixth information; and
the sixth information comprises at least one of the following:
mask information associated with each primary tactile signal; and
model information associated with each primary tactile signal.

20. The method according to claim 19, wherein the recovering at least part secondary tactile signals in the N second tactile signals based on the fifth information and a primary tactile signal in the N second tactile signals obtained by decoding comprises:
calculating, by the decoding end, a multiplication result between an amplitude of the primary tactile signal in the N second tactile signals and a fifth value, wherein the fifth value is a product of the masking threshold coefficient represented by the model information and the proportionality coefficient; and
recovering, by the decoding end, the at least part secondary tactile signals in the N second tactile signals according to the multiplication result.

21. A tactile signal encoding apparatus, comprising:
an obtaining module, configured to obtain N first tactile signals, wherein N is a positive integer greater than 1;
a first generating module, configured to generate M first signal blocks according to the N first tactile signals, wherein the first signal block comprises part signal sources of the N first tactile signals, and M is a positive integer greater than 1;
a first determining module, configured to determine, according to spatial information of the N first tactile signals, a target signal amplitude corresponding to a primary tactile signal in each first signal block, and a target frequency corresponding to the primary tactile signal in each first signal block, a temporal-spatial masking threshold matrix corresponding to each first signal block, wherein the first signal block comprises the primary tactile signal and a secondary tactile signal;
a filtering module, configured to filter out, based on the temporal-spatial masking threshold matrix corresponding to each first signal block, part secondary tactile signals comprised in each first signal block to obtain M second signal blocks; and
a first encoding module, configured to encode the N second tactile signals to generate a target bitstream, wherein the N second tactile signals are obtained based on a concatenation operation performed on the M second signal blocks.

22. The apparatus according to claim 21, wherein the first signal block comprises at least one primary tactile signal and at least one secondary tactile signal associated with the primary tactile signal; and
the first determining module is specifically configured to:
generate, for each first signal block, a spatial pattern mask associated with each primary tactile signal based on a relative position between each primary tactile signal represented by the spatial information and the at least one secondary tactile signal associated with each primary tactile signal, wherein the spatial pattern mask is used for representing a spatial position relationship between an associated primary tactile signal and the at least one secondary tactile signal associated with the primary tactile signal;
determine, according to the spatial pattern mask associated with each primary tactile signal and the spatial information, a psychohaptic masking model associated with each primary tactile signal, wherein each psychohaptic masking model comprises at least one masking threshold coefficient, the masking threshold coefficient is associated with a spatial position of the secondary tactile signal, and the masking threshold coefficient is determined based on a target frequency corresponding to the associated primary tactile signal;
determine, according to the target signal amplitude corresponding to each primary tactile signal and each masking threshold coefficient comprised in the psychohaptic masking model associated with each primary tactile signal, a spatial masking threshold matrix corresponding to each primary tactile signal, wherein each spatial threshold matrix comprises at least one masking threshold, the masking threshold is in a mapping correspondence with the secondary tactile signal, and the masking threshold is used for representing a masking effect of the primary tactile signal on the secondary tactile signal; and
obtain, according to the spatial masking threshold matrix corresponding to each primary tactile signal, at least one temporal-spatial masking threshold matrix corresponding to the first signal block.

23. The apparatus according to claim 22, wherein the first determining module is further specifically configured to:
perform a multiplication operation on the target signal amplitude corresponding to each primary tactile signal and each masking threshold coefficient comprised in the psychohaptic masking model associated with each primary tactile signal to obtain the spatial masking threshold matrix corresponding to each primary tactile signal.

24. The apparatus according to claim 22, wherein the first determining module is further specifically configured to:
obtain, in descending order of signal strength of all primary tactile signals and sequentially according to the spatial masking threshold matrix corresponding to each primary tactile signal, at least one temporal-spatial masking threshold matrix corresponding to the first signal block.

25. The apparatus according to claim 22, wherein the first determining module is further specifically configured to:
assign, for each primary tactile signal, at least one masking threshold at each target position in the spatial masking threshold matrix corresponding to the primary tactile signal to obtain a temporal-spatial masking threshold matrix corresponding to the primary tactile signal, wherein
the target position is used for representing a spatial position relationship between a primary tactile signal and a secondary tactile signal, the masking threshold assigned to the target position of the temporal-spatial masking threshold matrix is used for representing a masking effect of the primary tactile signal on the secondary tactile signal within an impact time period, and the impact time period is associated with a length of the first signal block.

26. The apparatus according to any one of claims 21 to 25, wherein the first generating module is specifically configured to:
perform low-pass filtering processing on the N first tactile signals; and
partition, by using occurrence time corresponding to the N first tactile signals obtained after the low-pass filtering processing as partitioning points, the N first tactile signals obtained after the low-pass filtering processing to generate M first signal blocks, wherein
initial time corresponding to each first tactile signal belonging to the same first signal block is the same.

27. The apparatus according to any one of claims 21 to 26, further comprising:
a processing module, configured to perform fast Fourier transform on the primary tactile signal in each first signal block to obtain spectrum information of each primary tactile signal; and
a second determining module, configured to determine, for each primary tactile signal, a highest frequency represented by the spectrum information of the primary tactile signal as the target frequency corresponding to the primary tactile signal.

28. The apparatus according to any one of claims 21 to 26, further comprising:
a third determining module, configured to determine, for each primary tactile signal in each first signal block, a signal amplitude of the primary tactile signal at initial occurrence time as the target signal amplitude corresponding to the primary tactile signal; or,
a fourth determining module, configured to determine a highest signal amplitude of the primary tactile signal as the target signal amplitude corresponding to the primary tactile signal.

29. The apparatus according to any one of claims 21 to 26, further comprising:
a calculating module, configured to calculate, for each first signal block, an average value of signal strength of N first tactile signals in the first signal block; and
a fifth determining module, configured to determine the primary tactile signal in the first signal block according to the average value.

30. The apparatus according to claim 29, wherein the fifth determining module is further specifically configured to perform at least one of the following:
determining, in a case that a difference between a maximum value of the signal strength of the N first tactile signals and the average value is less than a preset threshold, a first tactile signal associated with a preset spatial position in the N first tactile signals as the primary tactile signal in the first signal block; and
determining, in a case that a difference between a maximum value of the signal strength of the N first tactile signals and the average value is greater than or equal to a preset threshold, the primary tactile signal in the first signal block according to the signal strength of each of the N first tactile signals.

31. The apparatus according to any one of claims 21 to 30, wherein the temporal-spatial masking threshold matrix comprises a masking threshold corresponding to each secondary tactile signal, and the filtering module is specifically configured to:
filter out, for each first signal block, a secondary tactile signal that is in the first signal block and whose signal strength is less than a corresponding masking threshold.

32. The apparatus according to any one of claims 21 to 31, further comprising:
an obtaining module, configured to obtain third information;
a third generating module, configured to generate second metadata information according to the third information; and
a second encoding module, configured to encode the second metadata information to generate a first metadata information packet, wherein
the third information comprises spatial information of K third tactile signals, or comprises spatial information of K third tactile signals and fourth information, and K is a positive integer greater than 1; and
the fourth information comprises at least one of the following:
mask information associated with each primary tactile signal in the K third tactile signals; and
model information associated with each primary tactile signal in the K third tactile signals.

33. A tactile signal decoding apparatus, comprising:
a first obtaining module, configured to obtain a first metadata information packet;
a first decoding module, configured to decode the first metadata information packet to obtain second metadata information; and
a first parsing module, configured to parse the second metadata information to obtain third information, wherein
the third information comprises spatial information of K third tactile signals, or comprises spatial information of K third tactile signals and fourth information, and K is a positive integer greater than 1; and
the fourth information comprises at least one of the following:
mask information associated with each primary tactile signal in the K third tactile signals; and
model information associated with each primary tactile signal in the K third tactile signals.

34. A terminal, comprising a processor and a memory, wherein the memory stores a program or instructions executable on the processor, and the program or the instructions implement steps of the tactile signal encoding method according to any one of claims 1 to 18 or steps of the tactile signal decoding method according to claim 19 or 20 when executed by the processor.

35. A readable storage medium, wherein the readable storage medium stores a program or instructions, and the program or the instructions implement steps of the tactile signal encoding method according to any one of claims 1 to 18 or steps of the tactile signal decoding method according to claim 19 or 20 when executed by the processor.
